# EUROPÄISCHE PATENTSCHRIFT

(11) **EP 3 553 545 B1**
(45) Veröffentlichungstag und Bekanntmachung des Hinweises auf die Patenterteilung: **09.12.2020**
(21) Anmeldenummer: 19167319.3
(22) Anmeldetag: 04.04.2019
(51) Int. Cl.: G01R 33/30, G01R 33/31

(54) **TRANSPORTEINRICHTUNG FÜR TEMPERIERTE NMR-MESSPROBEN MIT DOPPELROHRSYSTEM**
TRANSPORT DEVICE FOR TEMPERATURE-CONTROLLED NMR MEASURING SAMPLES WITH DOUBLE-TUBE SYSTEM
DISPOSITIF DE TRANSPORT POUR ÉCHANTILLONS DE MESURE RMN TEMPÉRÉS POURVU DE SYSTÈME À TUBE DOUBLE

(30) Priorität: 12.04.2018 DE 102018205535
(43) Veröffentlichungstag der Anmeldung: 16.10.2019
(73) Patentinhaber: Bruker Switzerland AG, 8117 Fällanden (CH)
(72) Erfinder: Schmid, Reto, 8409 Winterthur (CH); Sieber, Sven, 8607 Seegräben (CH)
(74) Vertreter: Kohler Schmid Möbus Patentanwälte

(56) Entgegenhaltungen:
- US-A1- 2015 198 681

## Beschreibung

Die Erfindung betrifft eine Transporteinrichtung zur pneumatischen Beförderung von NMR-Messproben aus einem Bereich außerhalb eines NMR-Spektrometers durch einen rohrförmigen Transportkanal in das NMR-Spektrometer und von dort -gegebenenfalls nach Durchführung einer NMR-Messung an den NMR-Messproben- wieder nach außerhalb des NMR-Spektrometers, wobei die Transporteinrichtung eine Vorrichtung zur Erzeugung von Überdruck in dem NMR-Spektrometer-abgewandten Ende des rohrförmigen Transportkanals umfasst.

NMR-Spektrometer mit derartigen Transporteinrichtungen werden bereits seit vielen Jahrzehnten von der Anmelderin hergestellt und vertrieben. Sie sind beispielsweise in der DE 37 29 819 C2 (=Referenz [1]) beschrieben.

### Hintergrund der Erfindung

Eine Transportvorrichtung zur pneumatischen Beförderung der NMR-Messproben ist bekannt aus der Firmenbroschüre "Bruker Sample Transport. BST Installation and Technical Manual Version 002" der Bruker BioSpin AG vom 21. November 2008 (=Referenz [2]), insbesondere aus den Kapiteln 2, 3 und 5.7 - 5.9 dieser Publikation. Im Folgenden wird eine derartige Transportvorrichtung mit "BST" abgekürzt.

Zur schnellen und exakten Analyse der chemischen Zusammensetzung von Messproben oder zur Strukturbestimmung von in den Proben enthaltenen Stoffen werden seit über einem halben Jahrhundert NMR-Verfahren eingesetzt. Diese können in NMR-Spektrometern durchgeführt werden. Für diese Zwecke geeignete NMR-Spektrometer sind beispielsweise in der EP 2 199 816 B1 beziehungsweise in der US 8,217,655 B2 (=Referenz [3]) beschrieben.

Die NMR-Spektroskopie ist ein leistungsfähiges Verfahren der instrumentellen Analytik. Bei diesen NMR-Verfahren ist die Probe einem starken statischen Magnetfeld B₀ in einer z-Richtung ausgesetzt. Dabei kommt es zu einer Wechselwirkung mit den Kernspins des Probenmaterials, insbesondere zur Ausrichtung von Kernspins in der Messsubstanz. Sodann werden dazu orthogonale hochfrequente elektromagnetische Impulse in x- oder y-Richtung in die Probe eingestrahlt. Die zeitliche Entwicklung dieser Kernspins der Probe erzeugt wiederum hochfrequente elektromagnetische Felder, welche in der NMR-Apparatur detektiert werden. Aus den detektierten HF-Feldern können Informationen über die Eigenschaften der Probe integral über einen gewissen räumlichen Bereich erhalten werden. Insbesondere kann aus der Lage und Intensität von NMR-Linien auf die chemische Zusammensetzung sowie die chemischen Bindungsverhältnisse in der Probe geschlossen werden.

Die Messprobe besteht in der Regel aus einem zylindrischen Probenröhrchen mit üblicherweise kreisrundem, ovalem oder rechteckigem Querschnitt, welches die feste oder flüssige Messsubstanz enthält. Das Probenröhrchen ist mindestens auf der Seite verschlossen, mit der es zuerst in den Probenkopf des NMR-Spektrometers eindringt, und befindet sich typischerweise in einem Transportbehälter, dem sogenannten Spinner. Probenröhrchen und Spinner werden mit Hilfe des Transportsystems von außerhalb des Magneten in den Probenkopf transportiert. Die eingangs zitierte Referenz [1] beschreibt eine Transportvorrichtung zum Befördern eines solchen Probenröhrchen zwischen einem Eingabepunkt, an dem es in die Transportvorrichtung eingesetzt und entnommen werden kann, und einem Zuführungspunkt, an dem das Probenröhrchen einem Raumtemperatur-Rohr eines Kryostaten zugeführt werden kann, wobei der Eingabepunkt zum Zuführungspunkt sowohl horizontal als auch vertikal beabstandet ist, und wobei ein rohrförmiger Transportkanal zum pneumatischen Befördern des Probenröhrchens von einem ersten Transferpunkt am unteren Ende des Transportrohrs zu einem zweiten Transferpunkt an dessen oberem Ende vorgesehen ist.

Im Folgenden wird davon ausgegangen, dass sich die Einführungsöffnung oben am Probenkopf des NMR-Spektrometers befindet und das Probenröhrchen also von oben in den Probenkopf eingeführt wird. Es ist jedoch auch denkbar, das Probenröhrchen von unten in eine dafür vorgesehene Öffnung in den Probenkopf einzuführen. Dieser Fall ist analog zum oben genannten und soll aus Gründen der Übersichtlichkeit hier nicht näher beschrieben werden. Wenn das Probenröhrchen in der Messposition angekommen ist, befindet sich der Spinner innerhalb einer Turbine. Diese Turbine ermöglicht eine Rotation des Probenröhrchens (siehe etwa DE 10 2013 212 312 B4 = Referenz [4]).

Einen Probenwechsler mit Transport von Temperatur-kontrollierten NMR-Messproben in ein NMR-Spektrometer beschreibt die US 6,768,305 B1 (=Referenz [5]). Bei dieser Anordnung ist auch die Generierung von Signalen zur Ortserkennung der Messprobe im Transportsystem vorgesehen.

Die DE 10 2014 201 076 B3 (=Referenz [6]) zeigt eine Transporteinrichtung zum Transport einer NMR-Probe zum Probenkopf eines NMR-Spektrometers. Die Transporteinrichtung weist einen Transportbehälter für die Probe mit einer speziell modifizierten Verriegelungsvorrichtung auf. Der Transportbehälter ist so ausgelegt, dass er sowohl für den Transport eines HR-NMR Sample Spinners mit eingelegtem Probenröhrchen als auch eines NMR MAS-Rotors einsetzbar ist. Auf diese Weise kann ohne Umbauten des Transportsystems nur durch Auswechseln des Probenkopfes rasch zwischen NMR-Spektroskopie von Flüssigkeiten zu Festkörpern und umgekehrt gewechselt werden.

Generell sollte die Tot-Zeit zwischen zwei aufeinanderfolgenden Messungen im NMR-System möglichst kurz sein. Die NMR-Messproben sollten daher möglichst schnell gewechselt werden können. Ein geeignetes automatisierbares, kompaktes Schnellwechselsystem mit einer Sensoreinrichtung zur Erkennung eines Transportbehälters sowie mit speziellen Parkaufnahmen zum zeitweiligen Zwischenspeichern eines im Spektrometer ankommenden Transportbehälters wird in der-am Anmeldetag der vorliegenden Patentanmeldung noch nicht veröffentlichten-DE 10 2018 201 226.1 (=Referenz [7]) vorgeschlagen.

Wie auch schon oben angedeutet, wird üblicherweise die NMR-Messprobe in einen Transportträger (auch «Spinner» oder «Shuttle» genannt) gesteckt und dann mittels eines Gasstroms (meist Stickstoff oder Luft) in einem -theoretisch zylindrischen- Transportrohr transportiert. Die aktuelle Position des Transportträgers im Transportrohr ist jedoch nur schwer zu kontrollieren.

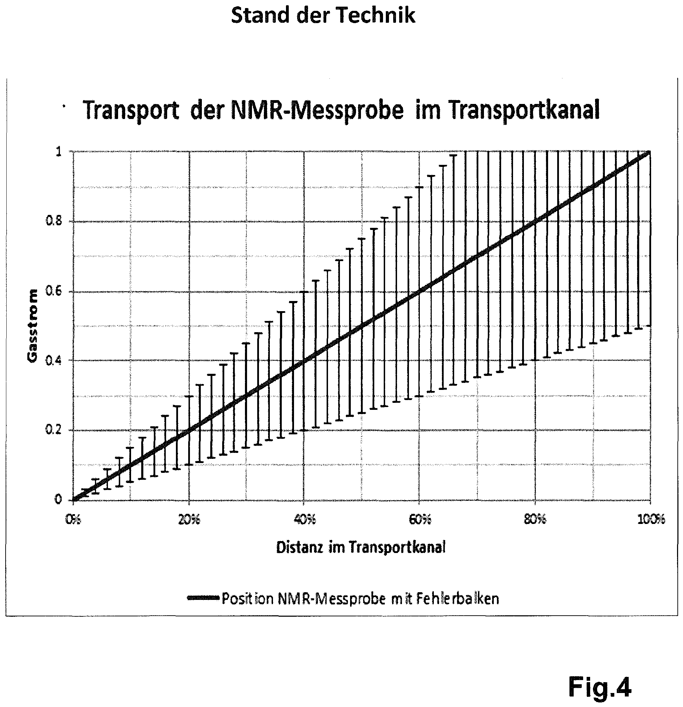

In der Regel existiert kein fester Zusammenhang zwischen der Stärke des Gaststroms und der Position des Transportträgers. Wie unten in Fig. 4 dargestellt, besteht bei den derzeit verwendeten Transportsystemen gemäß dem Stand der Technik eine große Unsicherheit über die genaue aktuelle Position der NMR-Messprobe im Transportkanal. Dies erkennt man deutlich aus der stetig und ziemlich stark zunehmenden Höhe der Fehlerbalken in Fig. 4. Diese Unsicherheit verhindert jedoch einen sanften, robusten aber trotzdem schnellen Transportvorgang der NMR-Messprobe. Aufgrund der hohen Masse eines herkömmlichen Transportträgers im Vergleich zur Masse der NMR-Messprobe kann das in der Regel aus Glas bestehende Probenröhrchen mit der NMR-Messprobe leicht beschädigt werden. Außerdem kann das Transportrohr, bedingt durch seine große Masse und Lage im Magneten, bisher nicht effektiv temperiert werden.

### Aufgabe der Erfindung

Der vorliegenden Erfindung liegt demgegenüber die Aufgabe zugrunde, eine Transporteinrichtung der eingangs definierten Art mit möglichst einfachen technischen Maßnahmen so zu modifizieren, dass die oben aufgezählten Nachteile vollständig oder zumindest weitestgehend vermieden werden, ohne damit eine Minderung der Qualität der NMR-Messungen hervorzurufen, wobei die NMR-Apparatur besonders kompakt bleiben soll und etwaige zusätzliche Materialkosten sowie weiterer Fertigungsaufwand unerheblich bleiben. Insbesondere soll die Erfindung eine möglichst exakte, aber auch technisch möglichst einfache und robuste Bestimmung der aktuellen Position der NMR-Messprobe im Transportkanal ermöglichen, wobei die Gefahr einer Beschädigung der NMR-Messprobe während ihres Transports durch den Transportkanal deutlich verringert werden soll. Die Erfindung soll außerdem problemlos eine wirksame Vortemperierung der Messproben möglich machen, so dass ein NMR-Experiment direkt nach dem Transport der jeweiligen Messprobe in das Magnetzentrum sofort und ohne weitere Vorbereitungszeit gestartet werden kann. Schließlich soll die erfindungsgemäße Änderung der bekannten Transporteinrichtung dahingehend konzipiert sein, dass sie ohne größere Umbauten optimal auch für vorhandene Systeme nach dem Stand der Technik einsetzbar ist, etwa für den SampleJet und den SampleCase der Anmelderin.

### Kurze Beschreibung der Erfindung

Diese relativ komplexe Aufgabe wird auf ebenso überraschend einfache wie wirkungsvolle Weise dadurch gelöst, dass bei einem gattungsgemäßen Transporteinrichtung zur pneumatischen Beförderung von NMR-Messproben mit den eingangs definierten Merkmalen der rohrförmige Transportkanal ein Rohrsystem umfasst, welches ein gasdichtes Außenrohr mit Außendurchmesser Dₐ und Innendurchmesser dₐ sowie ein koaxial dazu angeordnetes Innenrohr mit Außendurchmesser Dᵢ < dₐ und mit Innendurchmesser dᵢ aufweist, durch welches im Betrieb die Messproben befördert werden, und dass das Innenrohr in axialer Richtung voneinander beabstandete, als Durchgangsbohrungen ausgeführte Querbohrungen aufweist.

Die erfindungsgemäße Transporteinrichtung weist also im Gegensatz zur bisher üblichen Ausführung des einfachen Transportrohrs einen Transportkanal mit einem Doppelrohrsystem auf, das ein gasdichtes Außenrohr und ein mit radialem Abstand koaxial darin angeordnetes Innenrohr umfasst. Durch die erfindungsgemäß vorgeschriebenen Querbohrungen des Innenrohrs kann das aus der Überdruck-Vorrichtung eingepresste Transportgas jeweils zu einem gewissen Teil in den Hohlraum zwischen den beiden Rohren ausweichen. Durch den von der NMR-Messprobe im Innenrohr verursachten Gegendruck wird der Gasstrom jeweils unterhalb der NMR-Messprobe diese Ausweichmöglichkeit nutzen. Dies hat nun den großen Vorteil, dass je höher die NMR-Messprobe im inneren Transportrohr aufsteigt, umso mehr Gas durch diese kleinen Querlöcher verloren geht. Dadurch entsteht ein fester Zusammenhang zwischen der Größe des Gasstroms und der aktuellen Axialposition der NMR-Messprobe im inneren Transportrohr.

In pneumatischer Hinsicht verhält sich also das erfindungsgemäße DoppelrohrSystem wie ein geometrisch konisch ausgestaltetes, in seinem Querschnitt von unten nach oben zum Spektrometer hin sich verjüngendes einfaches Transportrohr, welches aber natürlich deutlich schwieriger herzustellen ist als das erfindungsgemäße Doppelrohrsystem. Durch die Verwendung eines solchen «pneumatisch konischen» Transportrohrs ist die aktuelle Axialposition des Transportträgers direkt abhängig vom aktuellen Volumenstrom des Transportgases und somit zu jedem Zeitpunkt des Transportvorgangs -und zwar ohne Einsatz zusätzlicher aufwändiger Detektionseinrichtungen- im Prinzip bekannt. Außerdem entstehen durch die -zunächst frei positionierbaren sowie in ihrer Größe und Anzahl frei wählbaren- Querbohrungen in axialer Richtung des Doppelrohrsystems diverse Beschleunigungszonen, in welchen die NMR-Messprobe besonders flott transportiert werden kann.

Insgesamt kann damit ein sehr robuster, schonender und trotzdem besonders schneller Transport der NMR-Messprobe ohne die Notwendigkeit einer besonderen Kalibration für unterschiedliche Massen bewerkstelligt werden. Wird zudem die Masse des Transportträgers stark reduziert oder gar der Transportträger gänzlich weggelassen, können die Möglichkeiten für eine Beschädigung der NMR-Messprobe während ihres Transports massiv reduziert werden.

Gerade aufgrund der durch die Erfindung eröffneten Möglichkeiten einer verbesserten automatisierten Schnellzuführung von -idealerweise sogar schon vortemperierten- NMR-Messproben wird es ermöglicht, den NMR-Messzyklus sehr kurz zu halten, da ein Vortemperieren der NMR-Messproben im Spektrometer problemlos auf die Zeitdauer des Transports der Proben durch den Transportkanal vorverlagert werden kann und somit nicht mehr den NMR-Messzyklus -unnötig- verlängert. Gerade durch diese zeitliche Verkürzung des Messzyklus ergeben sich hohe wirtschaftliche Vorteile, da mehr Messungen in der gleichen Zeit durchgeführt werden können.

An dieser Stelle sei ausdrücklich darauf hingewiesen, dass sich die Vorteile der Erfindung nicht nur bei vertikalen NMR-Spektrometern, sondern ebenso auch bei NMR-Systemen mit horizontaler oder schräg liegender z-Achse erzielen lassen. Die angegebenen axialen Positionen müssen dann nicht mehr notwendig "oberhalb" beziehungsweise "unterhalb" des NMR-Magnetspulensystems liegen, sondern gegebenenfalls auch "rechts" oder "links" neben demselben. Jedenfalls spielt die Schwerkraft bei der Wirkungsweise der vorliegenden Erfindung eine untergeordnete Rolle.

### Bevorzugte Ausführungsformen der Erfindung

Je nach speziellem Einsatzzweck können Ausführungsformen der erfindungsgemäßen Transporteinrichtung von besonders hohem Nutzen sein, bei denen die Querbohrungen in axialer Richtung des Innenrohrs in unterschiedlichen Distanzen und/oder unterschiedlichen Querbohrungsdurchmessern angeordnet sind. Dies kann etwa von Vorteil sein, wenn ein nichtlineares Transportprofil (Gasfluss zur Transportdistanz) mit sanften Beschleunigungsphasen erforderlich ist, beispielsweise beim Transport von fragilen, dünnwandigen NMR-Probengläschen.

Ganz besonders bevorzugt ist aber eine Klasse von Ausführungsformen der erfindungsgemäßen Transporteinrichtung, bei welchen die Querbohrungen in axialer Richtung des Innenrohrs äquidistant angeordnet sind. Dies kann besonders im mittleren Transportbereich zwischen Magnetzentrum und einer nach oben offenen Magnetbohrung vorteilhaft sein, wenn die NMR-Messprobe mit einer konstanten Geschwindigkeit befördert werden soll.

Weitere vorteilhafte Ausführungsformen der Erfindung sind dadurch gekennzeichnet, dass eine das Außenrohr umgebende thermische Isolationseinrichtung vorhanden ist. Durch ein temperiertes Transportrohr, vorzugsweise auf der für die NMR-Messprobe vorgesehenen Messtemperatur, kann erreicht werden, dass sich die Temperatur der NMR-Messprobe während des Transports nicht ändert. Dadurch kann die NMR-Messung sofort bei Ankunft im Probenkopf gestartet werden, ohne zusätzliche Wartezeit für die Temperaturstabilisierung.

Bevorzugt ist auch eine Ausführungsform der erfindungsgemäßen Transporteinrichtung, bei der eine Schutzhülle das Rohrsystem umgibt. Dadurch wird die oftmals sehr empfindliche thermische Isolation soweit geschützt, dass sie beim Ein- und -Ausbau des Systems nicht beschädigt oder verletzt werden kann.

Des Weiteren ist auch eine Klasse von Ausführungsformen der Erfindung von Vorteil, bei welchen die Transporteinrichtung eine Vorrichtung zur Erzeugung von Unterdruck in dem NMR-Spektrometer-zugewandten Ende des rohrförmigen Transportkanals umfasst. Ein Ansaugen der NMR-Probe ist vorteilhaft für das Gasflusssystem im NMR-Probenkopf, indem das aus dem NMR-Probenkopf austretende Temperier-Gas ungehindert abfließen kann und zudem ein Ansaugen der NMR-Probe aus einem Speicher (z.B. Rack) und auch der NMR-Messzelle in einfacher Weise umsetzbar ist.

Bei weiteren bevorzugten Ausführungsformen ist das erfindungsgemäße Doppelrohrsystem so gestaltet, dass es radial innerhalb eines Standard-Transportrohrs nach dem Stand der Technik angeordnet werden kann.

Dies hat den Vorteil, dass auch bestehende NMR-Magnetsysteme mit dem neuen Transportsystem nachgerüstet werden können, was dem Umstand Rechnung trägt, dass die NMR-Magneten typischerweise eine sehr hohe Lebens- und Verwendungsdauer von 20-30 Jahre besitzen.

In der Praxis bewähren sich auch Ausführungsformen, bei welchen das Rohrsystem folgende Dimensionierungen aufweist:
Außendurchmesser Dₐ des Außenrohrs: 15mm ≤ Dₐ ≤ 30mm, vorzugsweise 18mm ≤ Dₐ ≤ 26mm;
Innendurchmesser dₐ des Außenrohrs: 10mm ≤ dₐ ≤ 25mm, vorzugsweise 15mm ≤ dₐ ≤ 20mm;
Außendurchmesser Dᵢ des Innenrohrs: 7,5mm ≤ Dᵢ ≤ 15mm, vorzugsweise 10mm ≤ Dᵢ ≤ 12mm;
Innendurchmesser dᵢ des Innenrohrs: 5mm ≤ dᵢ ≤ 10mm, vorzugsweise 8,5mm ≤ dᵢ ≤ 9,5mm;
axialer Abstand A_{Q} der Querbohrungen: 50mm ≤ A_{Q} ≤ 300mm.

Dabei können die Durchmesser der Rohre Material-abhängig gewählt werden, sodass die mechanische Stabilität (insbesondere die Biegung), die thermischen Eigenschaften (etwa Ausdehnung, Wärmeleitung, etc.), die tribologischen Eigenschaften (insbesondere die Reibung) und die elektrische Ableitfähigkeit (vor allem die elektrostatische Aufladung) für den Einsatzzweck optimiert sind. Dies erlaubt eine kostengünstige und rationelle Herstellung.

Vorteilhaft sind Ausführungsformen der erfindungsgemäßen Transporteinrichtung, bei denen die NMR-Messproben für den Betrieb von einem Transportbehälter umgeben sind, dessen Masse M_{T} << 50g, insbesondere M_{T} < 40g, vorzugsweise M_{T} ≤ 25g. Dies ist vorteilhaft, da die aktuellen Standard-Transportbehälter auch beim neuen Transportverfahren verwendet werden können, was sich auch auf die Akzeptanz beim Kunden positiv auswirken kann, da er seine vielen Transportbehälter weiterverwenden kann.

Besonders bevorzugt schließlich ist eine Klasse von Ausführungsformen der erfindungsgemäßen Transporteinrichtung, die sich dadurch auszeichnen, dass sich die NMR-Messproben für den Betrieb jeweils in einem, vorzugsweise zylindrischen, Probenröhrchen mit Außendurchmesser D_{PR} befinden, und dass die Probenröhrchen im Betrieb jeweils durch eine einseitig aufgebrachte Verschlusskappe mit maximalem Außendurchmesser D_{VK} fluiddicht verschlossen sind. Durch den Verzicht auf den, im Vergleich zum Gewicht der NMR-Messprobe schweren Transportbehälter, können viel schnellere Transportzyklen mit entsprechend höheren Beschleunigungen verwendet werden, ohne Gefahr zu laufen, dass die empfindliche NMR-Messprobe beschädigt wird, z.B. das Glas bricht etc. Des Weiteren wird durch das reduzierte Gewicht auch eine erhebliche Reduktion des Verbrauchs an Transportgasen erreicht.

Bei vorteilhaften Weiterbildungen dieser Klasse von Ausführungsformen sind die Probenröhrchen und die Verschlusskappen so dimensioniert sind, dass gilt: dᵢ ≥ D_{VK} > D_{PR}. Die Verschlusskappe übernimmt zugleich die Funktion der Dichtlippe um den Auftrieb im Transportrohr zu generieren. Die bestehenden Verschlusskappen der Standard-4Zoll NMR-Messproben können diese Funktion bereits heute erfüllen.

In den Rahmen der vorliegenden Erfindung fällt auch ein Verfahren zum Betrieb einer erfindungsgemäßen Transporteinrichtung der oben beschriebenen Art, mit folgenden Schritten:
(a) Zuführung einer von einer Aufgabestelle, insbesondere einem Präparationsroboter, außerhalb des NMR-Spektrometers übernommenen NMR-Messprobe durch den externen Teil des Transportkanals zum Eintrittspunkt in das NMR-Spektrometer;
(b) Umsetzen der NMR-Messprobe in eine für den Weitertransport in den NMR-Magneten günstige räumliche Lage, vorzugsweise parallel zur Magnet-Achse;
(c) pneumatisch kontrolliertes Einführen der NMR-Messprobe durch den internen Teil des Transportkanals in das Magnetzentrum des NMR-Magnetsystems;
(d) Durchführen einer NMR-Messung an der NMR-Messprobe im Magnetzentrum des NMR-Systems;
(e) pneumatischer Rücktransport der NMR-Messprobe aus dem Magnetzentrum nach außerhalb des NMR-Spektrometers;
(f) gegebenenfalls Weitertransport der vermessenen NMR-Messprobe durch den externen Teile des Transportkanal zurück zur Aufgabestelle, z.B. einem Präparationsroboter.

Bei einem NMR-Spektrometer mit vertikal angeordneter Raumtemperatur-Bohrung befindet sich der Eintrittspunkt in der Regel oben auf dem NMR-System. Die bevorzugte Positionierung des Probenröhrchens mit der NMR-Messprobe in Schritt (b) wird dann so erfolgen, dass die Längsachse des Röhrchens in der Senkrechten steht. Möglicherweise sind auf dem NMR-System auch bereits mehrere andere NMR-Messproben gelagert, die alle auf die bevorzugte NMR-Messtemperatur gebracht, zumeist erhitzt, und/oder auf der gewünschten Temperatur gehalten werden. Ein erheblicher Vorteil dieses Verfahrens ist unter anderem ein schneller Wechsel der jeweils zu vermessenden Probe sowie ein zuverlässigerer Transport bei unterschiedlich schweren NMR-Messproben als dies heute möglich ist.

Vorteilhafte Weiterbildungen dieses Verfahrens sind dadurch gekennzeichnet, dass aus dem Verhältnis der aus den Querbohrungen austretenden Luft zum Gesamtvolumenstrom und dem dadurch vorliegenden direkten Zusammenhang zwischen Gesamtvolumenstrom und der axialen Position einer NMR-Messprobe im Transportkanal die aktuelle axiale Position der NMR-Messprobe bekannt ist. Dies erlaubt einen zuverlässigeren Betrieb mit kürzeren Wechselzeiten auch bei herstellungsbedingten Variationen in der Geometrie wie auch dem Gewicht der NMR-Messprobe.

Alternativ oder ergänzend können auch Weiterbildungen des erfindungsgemäßen Verfahrens zum Einsatz gelangen, bei welchen das Innenrohr unter Ausnutzung der das Außenrohr umgebenden thermischen Isolationseinrichtung auf einer konstanten Temperatur, vorzugsweise auf der Temperatur der NMR-Probe während der NMR-Messung gehalten wird, wobei diese Temperatur von der ungeregelten Temperatur des Transportkanals thermisch isoliert ist. Durch ein temperiertes Transportrohr, vorzugsweise auf der für die NMR-Messprobe vorgesehenen Messtemperatur, kann erreicht werden, dass sich die Temperatur der NMR-Messprobe während des Transports nicht ändert. Dadurch kann die NMR-Messung sofort bei Ankunft im Probenkopf gestartet werden, ohne zusätzliche Wartezeit für die Temperaturstabilisierung.

Besonders bevorzugt sind auch Varianten des erfindungsgemäßen Verfahrens, welche sich dadurch auszeichnen, dass die NMR-Messprobe zur Durchführung einer NMR-Messung zusätzlich zu einem Anblasen durch die Vorrichtung zur Erzeugung von Überdruck auch mittels der Vorrichtung zur Erzeugung von Unterdruck in das NMR-Spektrometer gesaugt wird. Ein Ansaugen der NMR-Messprobe ist vorteilhaft für das Gasflusssystem im NMR-Probenkopf, weil dadurch das aus dem NMR-Probenkopf austretende Temperiergas ungehindert abfließen kann und zudem ein Ansaugen der NMR-Messprobe aus einem Speicher (z.B. einem Rack) und auch einer NMR-Messzelle technisch einfach umsetzbar ist.

In den Rahmen der vorliegenden Erfindung schließlich fällt auch ein NMR-Spektrometer mit einer erfindungsgemäß modifizierten Transporteinrichtung der oben beschriebenen Art.

Weitere Vorteile der Erfindung ergeben sich aus der Beschreibung und der Zeichnung. Ebenso können die vorstehend genannten und die noch weiterausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert.

Es zeigen:
- Fig. 1: eine schematisierte, teilweise Vertikalschnitt-Ansicht auf eine Ausführungsform der erfindungsgemäßen Transporteinrichtung mit einer NMR-Messprobe ohne Transportbehälter, aber mit Verschlusskappe;
- Fig. 2: eine schematische vertikale Schnittansicht einer Transporteinrichtung nach dem Stand der Technik;
- Fig. 3: eine teil-transparente vertikale Schnittansicht eines NMR-Spektrometers mit einer Transporteinrichtung nach dem Stand der Technik;
- Fig. 4: Zusammenhang zwischen der von der NMR-Messprobe in einer Transporteinrichtung nach dem Stand der Technik zurückgelegten Distanz und der Größe des Gasstroms mit entsprechenden Fehlerbalken für die axiale Position der NMR-Messprobe; und
- Fig. 5: der Zusammenhang aus Fig. 4 bei einer erfindungsgemäßen Transporteinrichtung.

Generell befasst sich die vorliegende Erfindung mit einer modifizierten Transporteinrichtung von Messproben zu und von einem **NMR-Spektrometer 1.** Die Vorteile der Erfindung können aber auch bei einem Spektrometer mit anderer physikalischer Messtechnik genutzt werden, wobei dann womöglich entsprechende geeignete Modifikationen vorgenommen werden müssen.

Bereits im Stand der Technik weist eine solche Transporteinrichtung zur pneumatischen Beförderung von **NMR-Messproben 2** aus einem Bereich außerhalb eines NMR-Spektrometers 1 durch einen rohrförmigen **Transportkanal 3** in das NMR-Spektrometer 1 und von dort -gegebenenfalls nach Durchführung einer NMR-Messung an den NMR-Messproben 2- wieder nach außerhalb des NMR-Spektrometers 1 eine **Vorrichtung 4 zur Erzeugung von Überdruck** in dem NMR-Spektrometer-abgewandten Ende des rohrförmigen Transportkanals 3 auf.

Die erfindungsgemäße Transporteinrichtung zeichnet sich demgegenüber dadurch aus, dass der rohrförmige Transportkanal 3 ein Rohrsystem umfasst, welches ein **gasdichtes Außenrohr 5** mit Außendurchmesser Dₐ und Innendurchmesser dₐ sowie ein koaxial dazu angeordnetes **Innenrohr 6** mit Außendurchmesser Dᵢ < dₐ und mit Innendurchmesser dᵢ aufweist, wobei der Innendurchmesser dᵢ des Innenrohrs 6 größer oder gleich dem Außendurchmesser D_{P} der NMR-Messproben 2 gewählt ist, und dass das Innenrohr 6 in axialer Richtung voneinander beabstandete, als Durchgangsbohrungen ausgeführte **Querbohrungen 7** aufweist.

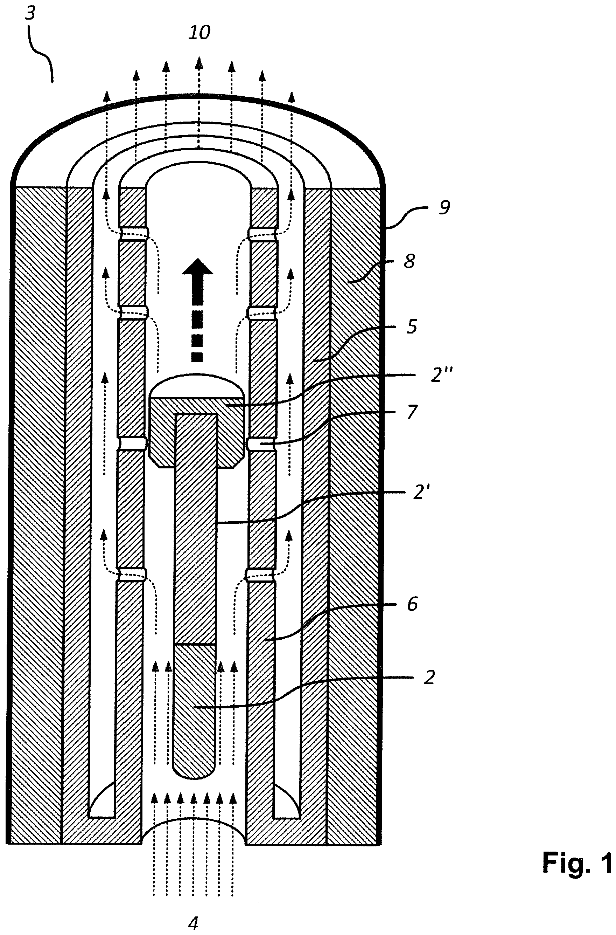

Die Querbohrungen 7 können prinzipiell an beliebigen axialen Positionen des Innenrohrs 6 vorgesehen werden. Bei dem in **Fig. 1** dargestellten Ausführungsbeispiel der Erfindung sind sie jedoch in axialer Richtung des Innenrohrs 6 äquidistant angeordnet.

Bei dieser Ausführungsform ist außerdem eine das Außenrohr 5 umgebende **thermische Isolationseinrichtung 8** vorhanden. Außerdem umgibt hier eine **Schutzhülle 9** das Rohrsystem 5, 6. Schließlich umfasst bei diesem Ausführungsbeispiel der Erfindung die Transporteinrichtung eine **Vorrichtung 10 zur Erzeugung von Unterdruck** in dem NMR-Spektrometer-zugewandten Ende des rohrförmigen Transportkanals 3. Das "pseudo-konische" DoppelrohrSystem 5, 6 kann also sowohl mittels der Vorrichtung 4 angeblasen als auch durch die Vorrichtung 10 abgesaugt werden.

Üblicherweise befinden sich die NMR-Messproben 2 im Betrieb jeweils in einem, vorzugsweise zylindrischen, **Probenröhrchen 2'** mit Außendurchmesser D_{PR}. Im Betrieb sind diese Probenröhrchen 2' jeweils durch eine einseitig aufgebrachte **Verschlusskappe 2"** mit maximalem Außendurchmesser D_{VK} fluiddicht verschlossen. Die Probenröhrchen 2' und die Verschlusskappen 2" sind dabei so dimensioniert, dass gilt: dᵢ ≥ D_{VK} > D_{PR}.

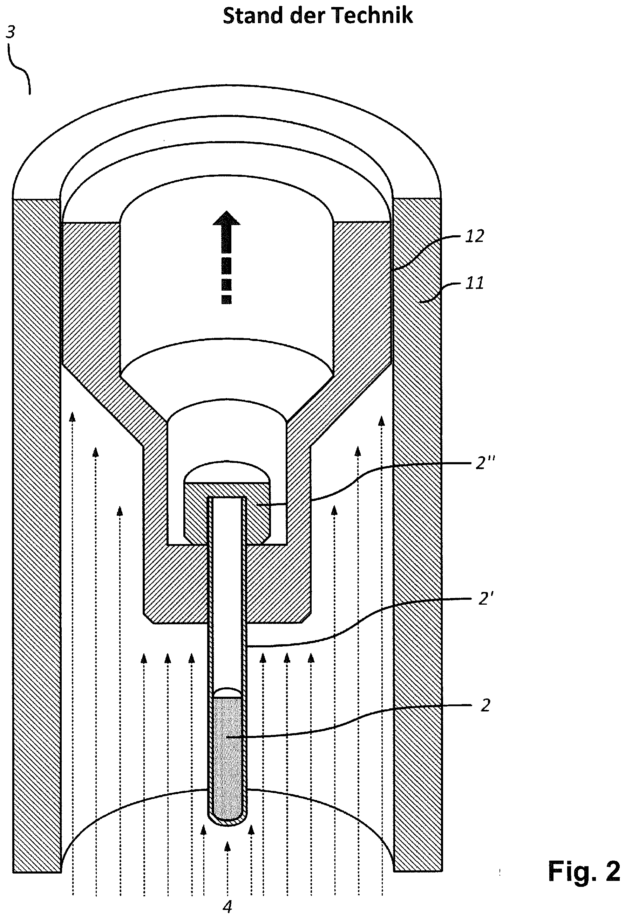

**Fig. 2** stellt eine Transporteinrichtung nach dem Stand der Technik dar. Hier fehlt also das erfindungsgemäße Doppelrohrsystem 5, 6. Stattdessen ist das Probenröhrchen 2' mit seiner Verschlusskappe 2" von einem **Transportbehälter 12** umgeben, welcher an seiner Außenkontur radial innerhalb eines **Standard-Transportrohrs 11** geführt wird.

Bei -in der vorliegenden Zeichnung nicht eigens dargestellten- weiteren Ausführungsformen der Erfindung kann aber auch das Doppelrohrsystem 5, 6 der erfindungsgemäßen Transporteinrichtung radial innerhalb eines vorhandenen herkömmlichen Standard-Transportrohrs 11 nach dem Stand der Technik angeordnet werden, wodurch eine Ab-Kompatibilität zu vorhandenen Einrichtungen hergestellt wird. Außerdem können bei Ausführungsformen der Erfindung die NMR-Messproben 2 im Betrieb ebenfalls von einem Transportbehälter 12 umgeben sein. Dieser wird jedoch in der Regel eine erheblich geringere Masse M_{T} als der beim Stand der Technik übliche Transportbehälter aufweisen, nämlich M_{T} << 50g, insbesondere M_{T} < 40g, vorzugsweise M_{T} ≤ 25g.

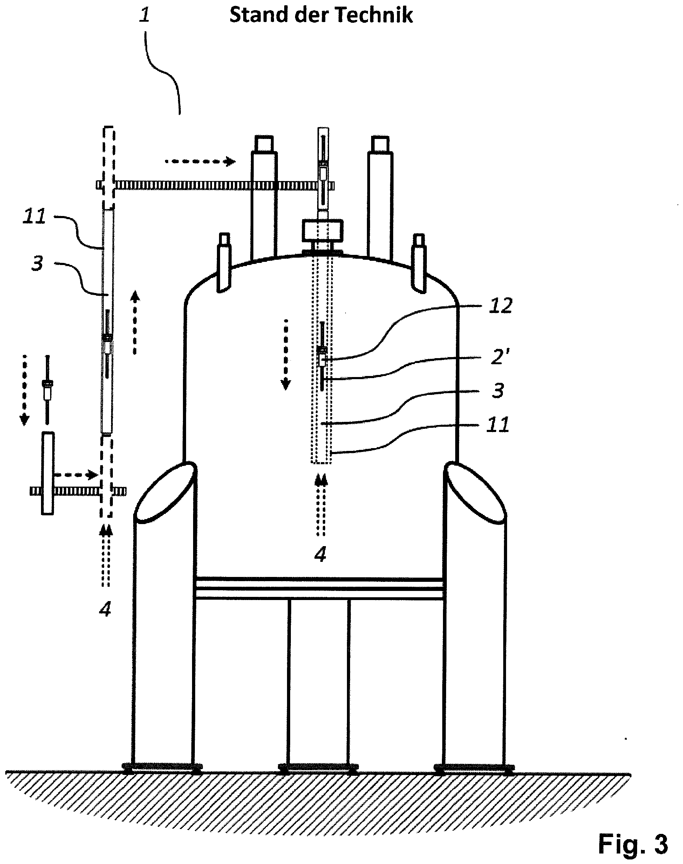

**Fig. 3** zeigt ein NMR-Spektrometer 1 mit einer Transporteinrichtung nach dem Stand der Technik, welche stattdessen aber auch gegen eine erfindungsgemäße Transporteinrichtung ausgetauscht werden könnte.

In **Fig. 4** ist der Zusammenhang zwischen der von der NMR-Messprobe in einer Transporteinrichtung nach dem Stand der Technik zurückgelegten Distanz und der Größe des Gasstroms mit entsprechenden Fehlerbalken für die axiale Position der NMR-Messprobe graphisch dargestellt. Bei den derzeit verwendeten Transportsystemen gemäß dem Stand der Technik herrscht eine große Unsicherheit über die genaue aktuelle Position der NMR-Messprobe im Transportkanal. Dies erkennt man deutlich aus der stetig und ziemlich stark zunehmenden Höhe der Fehlerbalken in Fig. 4.

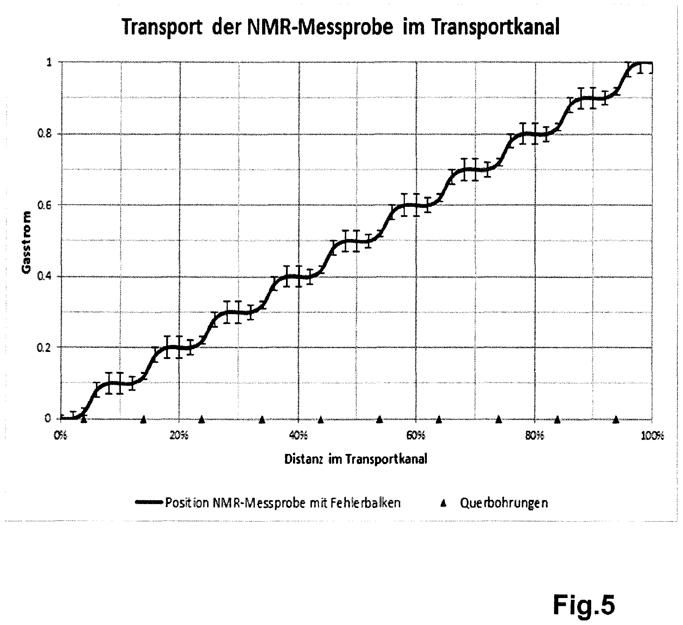

**Fig. 5** schließlich zeigt den Zusammenhang zwischen der von der NMR-Messprobe in einer erfindungsgemäßen Transporteinrichtung zurückgelegten Distanz und der Größe des Gasstroms mit entsprechenden Fehlerbalken für die axiale Position der NMR-Messprobe.

Durch die oben beschriebene erfindungsgemäße Modifikation der Transporteinrichtung entsteht ein fester Zusammenhang zwischen Gasstrom und Position der NMR-Messprobe 2 im Transportkanal 3, welcher in Fig. 5 als treppenförmige Kurve dargestellt ist. Jede Stufe entspricht dabei einer Position mit den Querlöchern 7 im inneren Transportrohr 6. Wie man deutlich erkennt, bleibt die Höhe der Fehlerbalken in Fig. 5 über die gesamte Transport-Distanz gleich groß. Damit ist die jeweilige aktuelle Position der NMR-Messprobe 2 während ihres Transports immer ziemlich genau definiert.

Durch das völlige Fehlen oder zumindest das erhebliche Verkleinern des Transportträgers 12 ist die Gesamtmasse der zu transportierenden NMR-Messprobe 2 sehr klein. Daher ist eine große Dynamik erreichbar bei gleichzeitig kleinstem Risiko einer Beschädigung der NMR-Messprobe. Der mögliche vollständige Wegfall des Transportträgers erlaubt zudem, das Innenrohr 6 und damit auch den Transportkanal 3 äußerst klein zu dimensionieren (typischerweise 9mm anstelle von bisher 26mm). Dadurch entsteht viel zusätzlicher Bauraum, der beispielsweise für eine thermische Isolierung 8 gegenüber dem NMR-Magneten sowie für eine zusätzliche Schutzhülle 9 genutzt werden kann. Hierdurch lassen sich unerwünschte Temperaturänderungen in der NMR-Messprobe 2 während des Transports ins NMR-Spektrometer 1 noch weiter reduzieren.

### Bezugszeichenliste:

- 1: NMR- Spektrometer
- 2: NMR-Messprobe
- 2': Probenröhrchen
- 2": Verschlusskappe
- 3: Transportkanal
- 4: Vorrichtung zur Erzeugung von Überdruck
- 5: Außenrohr
- 6: Innenrohr
- 7: Querbohrungen
- 8: Thermische Isolationseinrichtung
- 9: Schutzhülle
- 10: Vorrichtung zur Erzeugung von Unterdruck
- 11: Standard-Transportrohr
- 12: Transportbehälter

### Referenzliste:

Für die Beurteilung der Patentfähigkeit in Betracht gezogene Publikationen:
[1] DE 37 29 819 C2
[2] Firmenbroschüre Z31123"Bruker Sample Transport. BST Installation and Technical Manual Version 002" der Bruker BioSpin AG vom 21. November 2008
[3] EP 2 199 816 B1; US 8,217,655 B2
[4] DE 10 2013 212 312 B4
[5] US 6,768,305 B1
[6] DE 10 2014 201 076 B3
[7] DE 10 2018 201 226.1 (am 13.04.2018 noch nicht veröffentlicht)

## Patentansprüche

1. Transporteinrichtung zur pneumatischen Beförderung von NMR-Messproben (2) aus einem Bereich außerhalb eines NMR-Spektrometers (1) durch einen rohrförmigen Transportkanal (3) in das NMR-Spektrometer (1) und von dort wieder nach außerhalb des NMR-Spektrometers (1), wobei die Transporteinrichtung eine Vorrichtung (4) zur Erzeugung von Überdruck in dem NMR-Spektrometer-abgewandten Ende des rohrförmigen Transportkanals (3) umfasst,
**dadurch gekennzeichnet,**
**dass** der rohrförmige Transportkanal (3) ein Rohrsystem (5, 6) umfasst, welches ein gasdichtes Außenrohr (5) mit Außendurchmesser Dₐ und Innendurchmesser dₐ sowie ein koaxial dazu angeordnetes Innenrohr (6) mit Außendurchmesser Dᵢ < dₐ und mit Innendurchmesser dᵢ aufweist, durch welches im Betrieb die Messproben befördert werden,
und **dass** das Innenrohr (6) in axialer Richtung voneinander beabstandete, als Durchgangsbohrungen ausgeführte Querbohrungen (7) aufweist.

2. Transporteinrichtung nach Anspruch 1, **dadurch gekennzeichnet, dass** die Querbohrungen (7) in axialer Richtung des Innenrohrs (6) äquidistant angeordnet sind.

3. Transporteinrichtung nach einem der vorhergehenden Ansprüche, **dadurch gekennzeichnet, dass** eine das Außenrohr (5) umgebende thermische Isolationseinrichtung (8) vorhanden ist.

4. Transporteinrichtung nach einem der vorhergehenden Ansprüche, **dadurch gekennzeichnet, dass** eine Schutzhülle (9) das Rohrsystem (5, 6) umgibt.

5. Transporteinrichtung nach einem der vorhergehenden Ansprüche, **dadurch gekennzeichnet, dass** die Transporteinrichtung eine Vorrichtung (10) zur Erzeugung von Unterdruck in dem NMR-Spektrometer-zugewandten Ende des rohrförmigen Transportkanals (3) umfasst.

6. Transporteinrichtung nach einem der vorhergehenden Ansprüche, **dadurch gekennzeichnet, dass** das Rohrsystem (5, 6) radial innerhalb eines Standard-Transportrohrs (11) nach dem Stand der Technik angeordnet werden kann.

7. Transporteinrichtung nach einem der vorhergehenden Ansprüche, **dadurch gekennzeichnet, dass** das Rohrsystem (5, 6) folgende Dimensionierungen aufweist:
Außendurchmesser Dₐ des Außenrohrs (5): 15mm ≤ Dₐ ≤ 30mm,
vorzugsweise 18mm ≤ Dₐ ≤ 26mm;
Innendurchmesser dₐ des Außenrohrs (5): 10mm ≤ dₐ ≤ 25mm, vorzugsweise 15mm ≤ dₐ ≤ 20mm;
Außendurchmesser Dᵢ des Innenrohrs (6): 7,5mm ≤ Dᵢ ≤ 15mm, vorzugsweise 10mm ≤ Dᵢ ≤ 12mm;
Innendurchmesser dᵢ des Innenrohrs (6): 5mm ≤ dᵢ ≤ 10mm, vorzugsweise 8,5mm ≤ dᵢ ≤ 9,5mm;
axialer Abstand A_{Q} der Querbohrungen (7): 50mm ≤ A_{Q} ≤ 300mm.

8. System bestehend aus einer Transporteinrichtung nach einem der vorhergehenden Ansprüche sowie NMR-Messproben (2), **dadurch gekennzeichnet, dass** die NMR-Messproben (2) für den Betrieb von einem Transportbehälter (12) umgeben sind, dessen Masse M_{T} << 50g, insbesondere M_{T} < 40g, vorzugsweise M_{T} ≤ 25g.

9. System bestehend aus einer Transporteinrichtung nach einem der vorhergehenden Ansprüche sowie NMR-Messproben (2), **dadurch gekennzeichnet, dass** sich die NMR-Messproben (2) für den Betrieb jeweils in einem, vorzugsweise zylindrischen, Probenröhrchen (2') mit Außendurchmesser D_{PR} befinden, und dass die Probenröhrchen (2') für den Betrieb jeweils durch eine einseitig aufgebrachte Verschlusskappe (2") mit maximalem Außendurchmesser D_{VK} fluiddicht verschlossen sind.

10. System nach Anspruch 9, **dadurch gekennzeichnet, dass** die Probenröhrchen (2') und die Verschlusskappen (2") so dimensioniert sind, dass gilt: dᵢ ≥ D_{VK} > D_{PR}.

11. Verfahren zum Betrieb einer Transporteinrichtung nach einem der Ansprüche 1 bis 7 beziehungsweise eines Systems nach einem der Ansprüche 8 bis 10, **gekennzeichnet durch** folgende Schritte:
(a) Zuführung einer von einer Aufgabestelle außerhalb des NMR-Spektrometers (1) übernommenen NMR-Messprobe (2) **durch** den externen Teil des Transportkanals (3) zum Eintrittspunkt in das NMR-Spektrometer (1);
(b) Umsetzen der NMR-Messprobe (2) in eine für den Weitertransport in den NMR-Magneten günstige räumliche Lage;
(c) pneumatisch kontrolliertes Einführen der NMR-Messprobe (2) **durch** den internen Teil des Transportkanals in das Magnetzentrum des NMR-Magnetsystems;
(d) Durchführen einer NMR-Messung an der NMR-Messprobe (2);
(e) pneumatischer Rücktransport der NMR-Messprobe (2) aus dem Magnetzentrum nach außerhalb des NMR-Spektrometers (1);
(f) Weitertransport der vermessenen NMR-Messprobe (2) **durch** den externen Teile des Transportkanal (3) zurück zur Aufgabestelle.

12. Verfahren nach Anspruch 11 zum Betrieb einer Transporteinrichtung nach Anspruch 2 und gegebenenfalls einem der Ansprüche 3 bis 10, **dadurch gekennzeichnet, dass** aus dem Verhältnis der aus den Querbohrungen (7) austretenden Luft zum Gesamtvolumenstrom und dem dadurch vorliegenden direkten Zusammenhang zwischen Gesamtvolumenstrom und der axialen Position einer NMR-Messprobe (2) im Transportkanal (3) die aktuelle axiale Position der NMR-Messprobe (2) errechnet wird.

13. Verfahren nach Anspruch 11 oder 12 zum Betrieb einer Transporteinrichtung nach Anspruch 3 und gegebenenfalls einem der Ansprüche 4 bis 10, **dadurch gekennzeichnet, dass** das Innenrohr (6) unter Ausnutzung der das Außenrohr (5) umgebenden thermischen Isolationseinrichtung (8) auf einer konstanten Temperatur, vorzugsweise auf der Temperatur der NMR-Messprobe (2), während der NMR-Messung gehalten wird, wobei diese Temperatur von der ungeregelten Temperatur des Transportkanals (3) thermisch isoliert ist.

14. Verfahren nach einem der Ansprüche 11 bis 13 zum Betrieb einer Transporteinrichtung nach Anspruch 5 und gegebenenfalls einem der Ansprüche 6 bis 10, **dadurch gekennzeichnet, dass** die NMR-Messprobe (2) zur Durchführung einer NMR-Messung zusätzlich zu einem Anblasen durch die Vorrichtung (4) zur Erzeugung von Überdruck auch mittels der Vorrichtung (10) zur Erzeugung von Unterdruck in das NMR-Spektrometer (1) gesaugt wird.

15. NMR-Spektrometer (1) mit einer Transporteinrichtung nach einem der Ansprüche 1 bis 7 beziehungsweise mit einem System nach einem der Ansprüche 8 bis 10.

## Claims

1. Transport apparatus for pneumatically conveying NMR test samples (2) from a region outside an NMR spectrometer (1) through a tubular transport channel (3) into the NMR spectrometer (1), and from there back outside the NMR spectrometer (1), the transport apparatus comprising a device (4) for producing positive pressure in the end of the tubular transport channel (3) that is remote from the NMR spectrometer,
**characterized in that**
the tubular transport channel (3) has a tube system (5, 6) which comprises a gastight outer tube (5) having an outer diameter Dₐ and an inner diameter dₐ and an inner tube (6), arranged coaxially with respect to said outer tube, having an outer diameter Dᵢ < dₐ and an inner diameter dᵢ, through which the test samples are conveyed during operation,
and **in that** the inner tube (6) comprises cross-holes (7) that are mutually spaced in the axial direction and are designed as through-holes.

2. Transport apparatus according to claim 1, **characterized in that** the cross-holes (7) are arranged equidistantly in the axial direction of the inner tube (6).

3. Transport apparatus according to either of the preceding claims, **characterized in that** there is a thermal insulation means (8) surrounding the outer tube (5).

4. Transport apparatus according to any of the preceding claims, **characterized in that** a protective sleeve (9) surrounds the tube system (5, 6).

5. Transport apparatus according to any of the preceding claims, **characterized in that** the transport apparatus comprises a device (10) for generating negative pressure in the end of the tubular transport channel (3) that is nearer the NMR spectrometer.

6. Transport apparatus according to any of the preceding claims, **characterized in that** the tube system (5, 6) can be arranged radially inside a standard transport tube (11) according to the prior art.

7. Transport apparatus according to any of the preceding claims, **characterized in that** the tube system (5, 6) has the following dimensions:
outer diameter Dₐ of the outer tube (5): 15 mm ≤ Dₐ ≤ 30 mm, preferably 18 mm ≤ Dₐ ≤ 26 mm;
inner diameter dₐ of the outer tube (5): 10 mm ≤ dₐ ≤ 25 mm, preferably 15 mm ≤ dₐ ≤ 20 mm;
outer diameter Dᵢ of the inner tube (6): 7.5 mm ≤ Dᵢ ≤ 15 mm, preferably 10 mm ≤ Dᵢ ≤ 12 mm;
inner diameter dᵢ of the inner tube (6): 5 mm ≤ dᵢ ≤ 10 mm, preferably 8.5 mm ≤ dᵢ ≤ 9.5 mm;
axial distance A_{Q} between the cross-holes (7): 50 mm ≤ A_{Q} ≤ 300 mm.

8. System consisting of a transport apparatus according to any of the preceding claims as well as NMR test samples (2), **characterized in that**, for operation, the NMR test samples (2) are surrounded by a transport container (12) having a mass M_{T} << 50 g, in particular M_{T} < 40 g, preferably M_{T} ≤ 25 g.

9. System consisting of a transport apparatus according to any of the preceding claims as well as NMR test samples (2), **characterized in that**, for operation, the NMR test samples (2) are each located in a preferably cylindrical sample test tube (2') having an outer diameter D_{PR}, and **in that** for operation, the sample test tubes (2') are each sealed in a fluid-tight manner by a closure cap (2") which is attached at one end and has a maximum outer diameter D_{VK}.

10. System according to claim 9, **characterized in that** the sample test tubes (2') and the closure caps (2") are dimensioned such that: dᵢ ≥ D_{VK} > D_{PR}.

11. Method for operating a transport apparatus according to any of claims 1 to 7 or a system according to any of claims 8 to 10, **characterized by** the following steps:
(a) supplying an NMR test sample (2) which is acquired from a feed point outside the NMR spectrometer (1) through the external part of the transport channel (3) to the entry point into the NMR spectrometer (1);
(b) moving the NMR test sample (2) into a spatial position which is favorable for further transport into the NMR magnet;
(c) introducing the NMR test sample (2) through the internal part of the transport channel into the magnet center of the NMR magnet system in a pneumatically controlled manner;
(d) carrying out an NMR measurement on the NMR test sample (2);
(e) pneumatically transporting the NMR test sample (2) back out of the magnet center to outside the NMR spectrometer (1);
(f) further transporting the measured NMR test sample (2) through the external parts of the transport channel (3) back to the feed point.

12. Method according to claim 11 for operating a transport apparatus according to claim 2 and optionally any of claims 3 to 10, **characterized in that** the current axial position of the NMR test sample (2) is calculated from the ratio of the air escaping from the cross-holes (7) to the total volumetric flow rate and the direct relationship, produced as a result, between the total volumetric flow rate and the axial position of an NMR test sample (2) in the transport channel (3).

13. Method according to either claim 11 or claim 12 for operating a transport apparatus according to claim 3 and optionally any of claims 4 to 10, **characterized in that** the inner tube (6) is maintained at a constant temperature, preferably at the temperature of the NMR test sample (2), during the NMR measurement by using the thermal insulation means (8) surrounding the outer tube (5), said temperature being thermally insulated from the unregulated temperature of the transport channel (3).

14. Method according to any of claims 11 to 13 for operating a transport apparatus according to claim 5 and optionally any of claims 6 to 10, **characterized in that**, in order to carry out an NMR measurement, the NMR test sample (2) is suctioned into the NMR spectrometer (1) by means of the device (10) for generating negative pressure, in addition to being blown at by means of the device (4) for generating positive pressure.

15. NMR spectrometer (1) having a transport apparatus according to any of claims 1 to 7 or having a system according to any one of claims 8 to 10.

## Revendications

1. Dispositif de transport affecté au convoyage pneumatique d'échantillons de mesure RMN (2) vers un spectromètre RMN (1) à partir d'une région située à l'extérieur dudit spectromètre RMN (1), par l'intermédiaire d'un canal tubulaire de transport (3), puis de nouveau vers l'extérieur dudit spectromètre RMN (1), ledit dispositif de transport incluant un appareil (4) générateur de surpression dans l'extrémité dudit canal tubulaire de transport (3) qui pointe à l'opposé dudit spectromètre RMN,
**caractérisé par le fait**
**que** le canal tubulaire de transport (3) inclut un système de tubulures (5, 6) comprenant une tubulure extérieure (5) étanche aux gaz, munie d'un diamètre extérieur Dₐ et d'un diamètre intérieur dₐ, ainsi qu'une tubulure intérieure (6) qui est disposée coaxialement à la tubulure précitée, présente un diamètre extérieur Dᵢ < dₐ et un diamètre intérieur dᵢ, et par l'intermédiaire de laquelle les échantillons de mesure sont convoyés en service ;
et par le fait que ladite tubulure intérieure (6) est pourvue d'alésages transversaux (7) espacés les uns des autres dans la direction axiale et conçus comme des alésages traversants.

2. Dispositif de transport selon la revendication 1, **caractérisé par le fait que** les alésages transversaux (7) sont agencés à équidistance dans la direction axiale de la tubulure intérieure (6).

3. Dispositif de transport selon l'une des revendications précédentes, **caractérisé par** la présence d'un dispositif d'isolation thermique (8) entourant la tubulure extérieure (5).

4. Dispositif de transport selon l'une des revendications précédentes, **caractérisé par le fait qu'**une enveloppe protectrice (9) entoure le système de tubulures (5, 6).

5. Dispositif de transport selon l'une des revendications précédentes, **caractérisé par le fait que** ledit dispositif de transport inclut un appareil (10) générateur de dépression dans l'extrémité du canal tubulaire de transport (3) qui pointe vers le spectromètre RMN

6. Dispositif de transport selon l'une des revendications précédentes, **caractérisé par le fait que** le système de tubulures (5, 6) peut être logé radialement à l'intérieur d'un tube de transport (11) standard, conforme à l'art antérieur.

7. Dispositif de transport selon l'une des revendications précédentes, **caractérisé par le fait que** le système de tubulures (5, 6) présente les dimensionnements suivants :
diamètre extérieur Dₐ de la tubulure extérieure (5) : 15mm ≤ Dₐ ≤ 30mm, de préférence 18mm ≤ Dₐ ≤ 26mm;
diamètre intérieur dₐ de ladite tubulure extérieure (5) : 10mm ≤ dₐ ≤ 25mm, de préférence 15mm ≤ dₐ ≤ 20mm ;
diamètre extérieur Dᵢ de la tubulure intérieure (6) : 7,5mm ≤ Dᵢ ≤ 15mm, de préférence 10mm ≤ Dᵢ ≤ 12mm ;
diamètre intérieur dᵢ de ladite tubulure intérieure (6) : 5mm ≤ dᵢ ≤ 10mm, de préférence 8,5mm ≤ dᵢ ≤ 9,5mm ;
espacement axial A_{Q} des alésages transversaux (7) : 50mm ≤ A_{Q} ≤ 300mm.

8. Système comprenant un dispositif de transport conforme à l'une des revendications précédentes, ainsi que des échantillons de mesure RMN (2), **caractérisé par le fait que** les échantillons de mesure RMN (2) sont entourés, en vue de l'actionnement, par un conteneur de transport (12) dont la masse M_{T} << 50g, en particulier M_{T} < 40g, de préférence M_{T} ≤ 25g.

9. Système comprenant un dispositif de transport conforme à l'une des revendications précédentes, ainsi que des échantillons de mesure RMN (2), **caractérisé par le fait que** les échantillons de mesure RMN (2) sont logés à chaque fois, en vue de l'actionnement, dans un tube à essai (2') préférentiellement cylindrique, muni d'un diamètre extérieur D_{PR} ; et **par le fait que** les tubes à essai (2') sont respectivement obturés de manière étanche aux fluides, en vue de l'actionnement, par un capuchon obturateur (2") mis en place d'un côté et muni d'un diamètre extérieur maximal D_{VK}.

10. Système selon la revendication 9, **caractérisé par le fait que** les tubes à essai (2') et les capuchons obturateurs (2") sont dimensionnés de manière qu'il soit satisfait à : dᵢ ≥ D_{VK} > D_{PR}.

11. Procédé dédié à l'actionnement d'un dispositif de transport conforme à l'une des revendications 1 à 7, respectivement d'un système conforme à l'une des revendications 8 à 10, **caractérisé par** les étapes suivantes :
(a) amenée d'un échantillon de mesure RMN (2) prélevé d'un poste d'alimentation situé à l'extérieur du spectromètre RMN (1), par l'intermédiaire de la partie externe du canal de transport (3), vers le point d'entrée dans ledit spectromètre RMN (1) ;
(b) transfert dudit échantillon de mesure RMN (2) à une position spatiale propice à la poursuite du transport jusque dans l'aimant RMN ;
(c) introduction dudit échantillon de mesure RMN (2) contrôlée pneumatiquement, par l'intermédiaire de la partie interne dudit canal de transport, dans le centre de l'aimant du système magnétique RMN ;
(d) exécution d'une mesure RMN sur ledit échantillon de mesure RMN (2) ;
(e) transport pneumatique de retour dudit échantillon de mesure RMN (2) vers l'extérieur dudit spectromètre RMN (1), à partir dudit centre de l'aimant ;
(f) poursuite du transport de retour dudit échantillon de mesure RMN (2) mesuré, vers ledit poste d'alimentation, par l'intermédiaire de ladite partie externe dudit canal de transport (3).

12. Procédé selon la revendication 11, dédié à l'actionnement d'un dispositif de transport conforme à la revendication 2 et, le cas échéant, à l'une des revendications 3 à 10, **caractérisé par le fait que**, sur la base du rapport entre l'air sortant des alésages transversaux (7) et le débit volumique total, et de la corrélation directe qui en résulte, entre ledit débit volumique total et l'emplacement axial d'un échantillon de mesure RMN (2) dans le canal de transport (3), il s'opère un calcul de l'emplacement axial instantané dudit échantillon de mesure RMN (2).

13. Procédé selon la revendication 11 ou 12, dédié à l'actionnement d'un dispositif de transport conforme à la revendication 3 et, le cas échéant, à l'une des revendications 4 à 10, **caractérisé par le fait que** lors de la mesure RMN, en tirant parti du dispositif d'isolation thermique (8) entourant la tubulure extérieure (5), la tubulure intérieure (6) est maintenue à une température constante, de préférence à la température de l'échantillon de mesure RMN (2), cette température étant isolée thermiquement vis-à-vis de la température non régulée du canal de transport (3).

14. Procédé selon l'une des revendications 11 à 13, dédié à l'actionnement d'un dispositif de transport conforme à la revendication 5 et, le cas échéant, à l'une des revendications 6 à 10, **caractérisé par le fait que** pour l'exécution d'une mesure RMN, en plus d'une insufflation effectuée par l'appareil (4) générateur de surpression, l'échantillon de mesure RMN (2) est également aspiré dans le spectromètre RMN (1) au moyen de l'appareil (10) générateur de dépression.

15. Spectromètre RMN (1) équipé d'un dispositif de transport conforme à l'une des revendications 1 à 7, respectivement d'un système conforme à l'une des revendications 8 à 10.
